(19) Europäisches Patentamt / European Patent Office / Office européen des brevets

(11) **EP 4 168 736 B1**

(12) **FASCICULE DE BREVET EUROPEEN**

(45) Date de publication et mention de la délivrance du brevet:
**17.04.2024   Bulletin 2024/16**

(21) Numéro de dépôt: **21733459.8**

(22) Date de dépôt: **18.06.2021**

(51) Classification Internationale des Brevets (IPC):
***G01C 19/64*** *(2006.01)*

(52) Classification Coopérative des Brevets (CPC):
**G01C 19/64**

(86) Numéro de dépôt international:
**PCT/EP2021/066708**

(87) Numéro de publication internationale:
**WO 2021/259811 (30.12.2021 Gazette 2021/52)**

(54) **DISPOSITIF DE MESURE D'UNE GRANDEUR REPRÉSENTATIVE D'UNE POPULATION D'ATOMES FROIDS ET CAPTEUR ASSOCIÉ**

VORRICHTUNG ZUR MESSUNG EINER MENGE, DIE FÜR EINE POPULATION VON KALTEN ATOMEN REPRÄSENTATIV IST, UND ZUGEHÖRIGER SENSOR

DEVICE FOR MEASURING A QUANTITY REPRESENTATIVE OF A POPULATION OF COLD ATOMS AND ASSOCIATED SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **23.06.2020   FR 2006563**

(43) Date de publication de la demande:
**26.04.2023   Bulletin 2023/17**

(73) Titulaires:
• **Centre National de la Recherche Scientifique**
**75016 Paris (FR)**
• **Observatoire de Paris**
**75014 Paris (FR)**
• **SORBONNE UNIVERSITE**
**75006 Paris (FR)**

(72) Inventeur: **GARRIDO ALZAR, Carlos**
**75014 PARIS (FR)**

(74) Mandataire: **IPAZ**
**Bâtiment Platon**
**Parc Les Algorithmes**
**91190 Saint-Aubin (FR)**

(56) Documents cités:
**WO-A1-2017/089489**

• **BERND MEYER ET AL: "Dynamical low-noise microwave source for cold atom experiments", ARXIV.ORG, CORNELL UNIVERSITY LIBRARY, 201 OLIN LIBRARY CORNELL UNIVERSITY ITHACA, NY 14853, 24 mars 2020 (2020-03-24), XP081633615,**
• **MARK KEIL ET AL: "Fifteen Years of Cold Matter on the Atom Chip: Promise, Realizations, and Prospects", ARXIV.ORG, CORNELL UNIVERSITY LIBRARY, 201 OLIN LIBRARY CORNELL UNIVERSITY ITHACA, NY 14853, 16 mai 2016 (2016-05-16), XP080701478,**
• **ALEXANDER D CRONIN ET AL: "Atom Interferometers", ARXIV.ORG, CORNELL UNIVERSITY LIBRARY, 201 OLIN LIBRARY CORNELL UNIVERSITY ITHACA, NY 14853, 21 décembre 2007 (2007-12-21), XP080343435, DOI: 10.1103/REVMODPHYS.81.1051**
• **KRASNOK ALEXANDER E. ET AL: "An antenna model for the Purcell effect", SCIENTIFIC REPORTS , vol. 5, no. 1 20 janvier 2015 (2015-01-20), XP055776219, DOI: 10.1038/srep12956 Extrait de l'Internet: URL:https://arxiv.org/pdf/1501.04834.pdf [extrait le 2021-02-01] cité dans la demande**

EP 4 168 736 B1

**Description**

**DOMAINE DE L'INVENTION**

La présente invention concerne le domaine des capteurs à base de nuages d'atomes froids et plus particulièrement un dispositif permettant la mise en oeuvre de l'étape de détection d'un nombre d'atomes dans un état atomique prédéterminé, conduisant à la mesure de la grandeur souhaitée.

**ETAT DE LA TECHNIQUE**

Les capteurs à atomes froids ont déjà montré d'excellentes performances pour la mesure du temps (horloge), des champs de gravitation (gravimètre), des accélérations (accéléromètre), des rotations (gyromètre), du champ magnétique (magnétomètres). Ils peuvent également être utilisés dans le domaine de la spectroscopie.

Pour réaliser la mesure, un capteur à atomes froids nécessite l'obtention d'un nuage d'atomes froids, c'est-à-dire des atomes qui ont été ralentis selon les trois directions de l'espace, dans une enceinte à vide. Typiquement la température des atomes du nuage est inférieure à 10 $\mu$K. Ils sont préparés dans un état hyperfin donné.

Pour la mise en oeuvre du capteur, on distingue :

- une étape de préparation des atomes, consistant à réaliser le nuage précité;

- une étape de mesure interférométrique (horloge, accélération, rotation) proprement dite à partir du nuage. Une génération de capteurs à atomes froids utilise un microcircuit à atomes (« atom chip » en anglais) ou puce à atomes, qui comprend des microfils pour guider/piéger le/les nuage/s d'atomes froids près de sa surface.

- une étape de détection, consistant à convertir la phase interférométrique accumulée par la fonction d'onde atomique pendant la mesure en une différence de populations entre deux sous-niveaux Zeeman (niveaux hyperfins), puis à mesurer cette différence de population et enfin à déduire la grandeur physique recherchée à partir de cette différence de populations. Selon l'état de l'art cette lecture est réalisée en utilisant un laser de détection illuminant le nuage d'atomes froids.

Les atomes à détecter sont ceux refroidis puis manipulés sur les microcircuits de la puce à atomes. D'abord préparés dans un état fondamental hyperfin donné, ils sont guidés ou piégés sur le microcircuit à une distance h comprise entre 3 et une centaine de $\mu$m, et de manière à réaliser un interféromètre à atomes pour mesurer une grandeur inertielle.

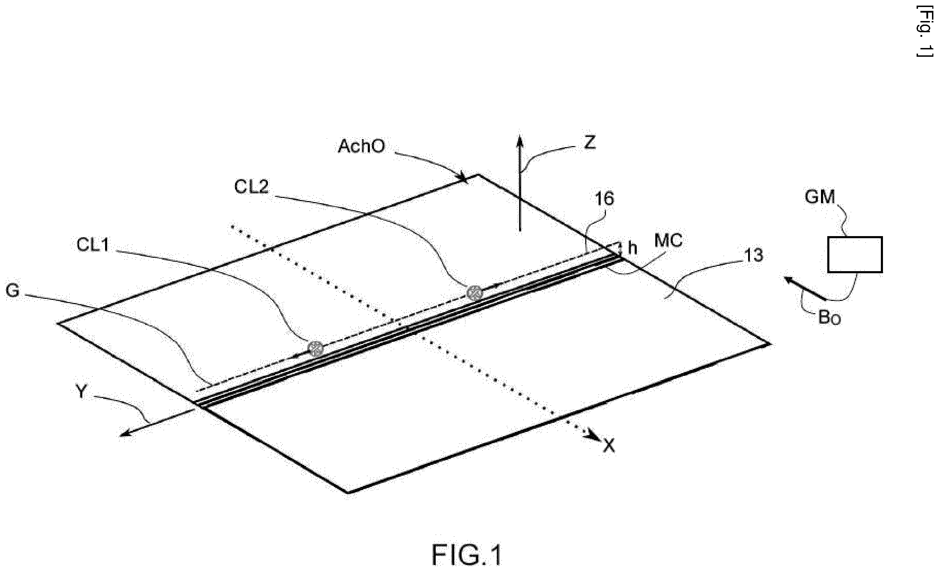

Un exemple de puce à atomes Ach0 pour capteur inertiel de type accéléromètre/gyromètre est illustré figure 1. On réalise ici un interféromètre à atomes pour mesurer cette grandeur inertielle. Une partie de la surface de la puce forme le plan de mesure 13. La figure 1 illustre une section d'un guide magnétique G généré par un microcircuit MC. Le microcircuit est par exemple un quadrupôle magnétique (crée par un ensemble de trois fils voir par 5 fils ou plus), un ensemble de guide hyperfréquence coplanaires et de fils conducteurs, .... De manière générale le microcircuit est alimenté de manière adéquate, par exemple par des générateurs de tension et/ou de courant continu et/ ou alternatif (RF) extérieurs à la puce à atomes ou par un champ magnétique extérieur.

Dans le guide magnétique G deux nuages d'atomes CL1 et CL2 sont guidés de manière à se propager en sens opposé selon une trajectoire 16. Le guide magnétique G est généré par les fils de la puce (par exemple un quadrupôle magnétique de guidage) pour guider les deux nuages d'atomes froids, à une distance prédéterminée h du plan de mesure 13. Le guide G est circulaire pour un gyromètre et linéaire pour un accéléromètre. Pour une mesure exclusivement d'horloge le nuage n'est pas déplacé. La vitesse de rotation $\Omega$ est mesurée par le gyromètre autour d'un axe Z normal au plan de mesure 13 de la puce 1. L'accélération est mesurée dans la direction du guide magnétique linéaire, le long de son axe (Y sur la figure 1).

Le déphasage $\theta$ induit par effet Sagnac entre deux ondes de matière contrarotatives dans un référentiel tournant à la vitesse angulaire $\Omega$, est donné par :

$$\theta = 2Am/\hbar \cdot \Omega \qquad (1)$$

où A est l'aire inscrite dans le la trajectoire, m la masse des atomes et $\hbar$ la constante de Planck réduite.

Le déphasage $\Phi$ dans la mesure d'accélération est donné par :

$$\Phi = 2kaT^2 \qquad (2)$$

où k est le vecteur d'onde du laser utilisé pour séparer (lancer), défléchir et recombiner les nuages d'atomes, 2T est la durée de l'interféromètre et a l'accélération à mesurer.

Pour une mesure d'accélération la trajectoire des deux nuages est monodimensionnelle, Pour une mesure de rotation la trajectoire est bidimensionnelle et pour une mesure d'horloge le nuage n'est pas déplacé.

Par exemple le nuage CL1 comprend des atomes froids dans l'état la> avec une vitesse v1=+v et le nuage CL2 comprend des atomes froids dans l'état |b> avec une vitesse v2=-v. Par exemple dans le cas du rubidium 87, les niveaux atomiques |a> et |b> sont espacés en vitesse de $4\hbar k/M$, mais ils correspondent au même état interne |F=2, mF=+2> (voir plus loin).

Lorsque les deux nuages ont effectué au moins une fois la trajectoire fermée, ou un aller/retour pour le cas linéaire, ils sont recombinés au point de départ (conversion de phase) et constituent alors les deux nuages à analyser.

Dans le capteur, la puce à atomes 1 est placée dans une enceinte à vide entretenu, par exemple, à l'aide d'une pompe ionique et comportant préférentiellement un blindage magnétique.

L'enceinte à vide comporte également une source d'atomes froids, comprenant:

Un source d'atomes (*dispenser* en anglais), par exemple réalisé par un filament chauffant délivrant une vapeur de rubidium,

un piège primaire à atomes (magnéto-optique), permettant de pré-refroidir et de disposer un nuage d'atomes froids initial au voisinage de la puce (étape de préparation).

L'enceinte à vide comporte également une source de champ magnétique GM, extérieure à la puce Ach0. Elle permet d'imposer un champ magnétique homogène et stationnaire B0 sur une épaisseur au moins de l'ordre d'une hauteur h au-dessus du plan de mesure 13. Avantageusement, la direction du champ magnétique homogène est parallèle au plan de mesure.

Les atomes utilisés dans les capteurs à atomes froids sont tels qu'ils présentent deux niveaux atomiques fondamentaux dits « hyperfins », c'est-à-dire séparés en fréquence d'une grandeur $f_H$ de l'ordre du gigahertz qui est très stable et très bien connue. Ces atomes sont typiquement du rubidium 87, pour lequel $f_H$ =6,834 GHz, mais d'autres atomes alcalins tels que le rubidium 85 ($f_H$ = 3.0 GHz) le césium ($f_H$ = 9.2 GHz), le sodium ($f_H$ = 1.7 GHz) ou le potassium 40 ($f_H$ = 1.3 GHz) ou des ions de terres rares comme l'ytterbium ($f_H$ = 12.6 GHz) présentent le même type de structure atomique et peuvent être utilisés. Lorsque les deux niveaux atomiques fondamentaux sont soumis à un champ magnétique homogène B0, ils se décomposent en sous niveaux Zeeman séparés chacun d'une fréquence f0 fonction du champ magnétique appliqué (typiquement quelques centaines de kHz par gauss). Ce champ dit de biais est utile au fonctionnement du capteur.

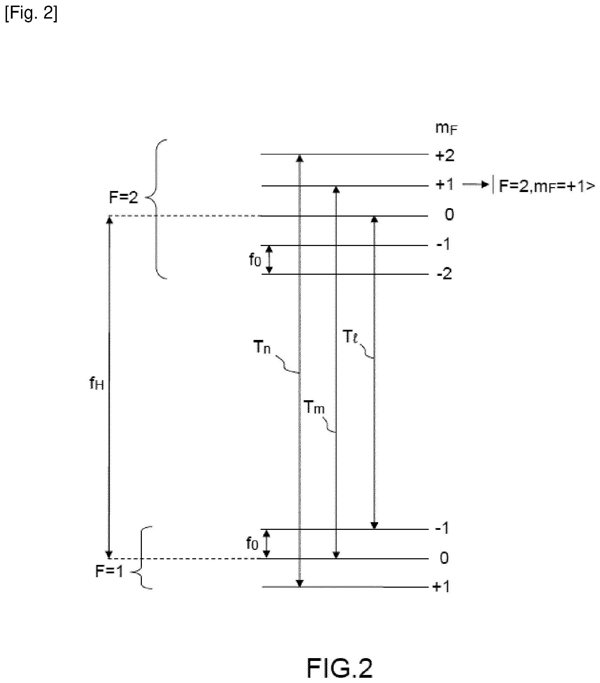

Pour le rubidium le niveau hyperfin le plus bas est dénommé F=1 et le niveau le plus haut F=2 et la figure 2 illustre les différents sous niveaux Zeeman associés, repérés par une valeur d'une grandeur $m_F$. Pour F=1, $m_F$ peut prendre les valeurs -1, 0, +1 et pour F=2 $m_F$ peut prendre les valeurs -2, -1, 0, +1, +2. Un état atomique est repéré selon la valeur de F et celle de mF, par exemple |F=1, $m_F$=-1 >.

La figure 2 illustre également trois transitions atomiques Tn, Tm et Tn connues (dites $\sigma+$ ) du rubidium 87 et utilisées pour le fonctionnement du capteur inertiel et on a :

- Transition Tn entre |F=2, $m_F$=+2> et |F=1, $m_F$=+1>, de fréquence $f_T=f_H+3f0$

- Transition Tm entre |F=2, $m_F$=+1> et |F=1, $m_F$=0>, de fréquence $f_T=f_H+f0$

- Transition Tl entre |F=2, $m_F$=0> et |F=1, $m_F$=-1>, de fréquence $f_T=f_H-f0$

Lors du fonctionnement du capteur de la figure 1, l'état de départ des atomes est l'un des sous-niveaux Zeeman (par exemple |F=2, mF=+2>) avec une vitesse nulle. Il est choisi en fonction du capteur et du type de mesure souhaitée.

A l'aide d'un laser qui produit une transition de Bragg on modifie la vitesse des atomes dans l'état de départ pour créer un état la> avec une vitesse v1=+v et un état |b> avec une vitesse v2=-v. Ainsi, l'état interne est toujours le même sous-niveau Zeeman, mais maintenant on a deux états la> et |b> différentiés en vitesse.

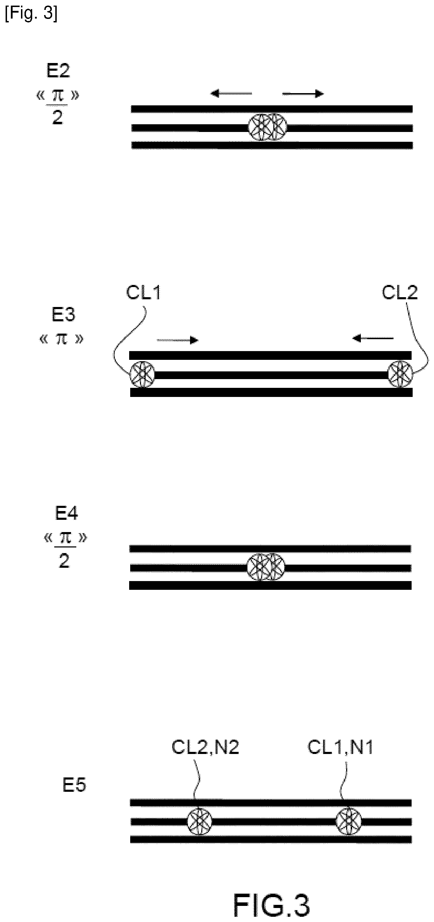

Le procédé de mesure d'une grandeur physique donnée (horloge, accélération, rotation, champ magnétique) par un capteur à puce à atomes comprend plusieurs étapes précitées (préparation, mesure, détection). Plus particulièrement les différentes étapes mise en oeuvre par un capteur à atomes froids tel qu'illustré figure 1 sont détaillées ci-dessous et illustrée figure 3.

L'étape E1 de préparation consiste à générer un nuage d'atomes froids, incluant l'émission par une source desdits atomes, le refroidissement desdits atomes, l'initialisation desdits atomes dans au moins un état atomique de guidage du nuage, par exemple $|F=2, m_F=+2>$, dans un minimum de potentiel magnétique.

L'étape de mesure comprend une (E2) ou deux (E2 et E3) sous étapes :

Dans une étape E2 les états atomique sont initialisés par superposition cohérente des atomes froids entre le premier état atomique la> de vitesse v1 et un deuxième état atomique |b> de vitesse v2.

$$|a> = |F=2, m_F=+2 \; ; \; v1=+v> \; ; \; |b> = |F=2, m_F=+2 \; ; \; v2=-v>.$$

Cette initialisation est réalisé par une première impulsion dite «π/2», qui prépare 50% des atomes dans l'état la> et l'autre 50% des atomes dans l'état |b>. Suite à cette impulsion on réalise deux nuages CL1 et CL2 comprenant des atomes respectivement dans les états la> et |b> et de vitesses opposées, et qui se séparent spatialement suivant une trajectoire prédéfinie.

Dans une étape E3 on échange les vitesses des atomes par une deuxième impulsion dite «π» pour les faire revenir au point de départ. L'état la> a alors une vitesse -v et l'état |b> une vitesse +v. Pour le cas d'un guide G circulaire, on attend seulement leur arrivée au point de départ, le temps d'atteinte étant fixé par le rayon du guide circulaire et la vitesse v.

L'étape de détection comprend également plusieurs sous étapes.

Une fois chaque nuage revenu au point de départ, dans une étape E4 on recombine les deux états atomiques de vitesse de manière à mélanger les deux états de propagation avec une troisième impulsion «π/2». Après la recombinaison les deux nuages CL1 et CL2, qui sont en propagation libre, se séparent à nouveau, et forment alors les deux nuages à analyser.

De manière générale qu'après une impulsion «π/2» (de séparation ou recombinaison) :

1) le nuage CL1 a toujours une vitesse v1 et contient N1 atomes.

2) le nuage CL2 a toujours une vitesse v2 et contient N2 atomes.

Alors, après la dernière impulsion «π/2», lors de la recombinaison :

1) le nuage CL1 contient N1 atomes dont p% des atomes étaient avant cette impulsion dans le nuage CL1 et (100-p)% des atomes étaient dans le nuage CL2 avant cette impulsion.

2) le nuage CL2 contient N2 atomes dont (100-p)% des atomes étaient avant cette impulsion dans le nuage CL1 et p% des atomes étaient dans le nuage CL2 avant cette impulsion.

En d'autres termes à la fin de la mesure par l'interféromètre on compte combien d'atomes ont la vitesse v1, combien d'atomes ont la vitesse v2, indépendamment de leur origine, nuage CL1 ou CL2, avant la dernière impulsion «π/2».

Dans d'autres types de capteurs, tel que celui de type gyromètre décrit dans le document WO 2017089489, lors de la recombinaison et après celle-ci le nuage atomique est piégé (on dit également garé) à sa position initiale, les deux nuages à analyser sont alors confondus, et il n'y a qu'un seul nuage d'atomes froids à analyser. Le microcircuit est ici constitué de deux guides microondes coplanaires et de fils conducteurs dans lesquels circule un courant continu, qui déplacent les deux nuages sur une trajectoire rectangulaire.

Lors de cette recombinaison on transfert la phase accumulée par la fonction d'onde atomique pendant la mesure en une différence de populations entre les deux sous-niveaux Zeeman la> et |b>. Soit N1 la population d'atomes de l'état la> et N2 la population d'atomes de l'état |b> après le transfert de la phase. Les deux probabilités Prob1 et Prob2 d'occupation par les atomes respectivement des deux niveaux atomiques la> et |b>, s'expriment alors selon les formules :

$$Prob_1 = \frac{N_1}{N_1 + N_2} = \frac{1}{2}[1 + \cos(\varphi + \varphi_o)] \qquad (3)$$

$$Prob_2 = \frac{N_2}{N_1 + N_2} = \frac{1}{2}\left[1 - \cos(\varphi + \varphi_o)\right] \qquad (4)$$

Avec cp phase recherchée et $\varphi_o$ la phase qui définit le point de fonctionnement/opération du capteur.

Dans une étape E5' on mesure le nombre d'atomes (population) N1 dans l'état la> pour le nuage CL1 et N2 dans l'état |b> pour le nuage CL2, qui permettent de calculer les probabilités Prob1 et Prob2. Elles sont le rapport entre le nombre d'atomes dans les états la> et |b> respectivement et le nombre total d'atomes participant dans la mesure. Puis on détermine la phase à partir de Prob1 et Prob2

Enfin dans une étape E6 on détermine la grandeur physique recherchée à partir de la phase.

Selon l'état de l'art l'étape E5', c'est-à-dire la détection d'un signal à la sortie d'un interféromètre à atomes, est réalisée en utilisant un laser de détection illuminant le nuage d'atomes froids à analyser, ici dénommé CL. Deux méthodes sont utilisées.

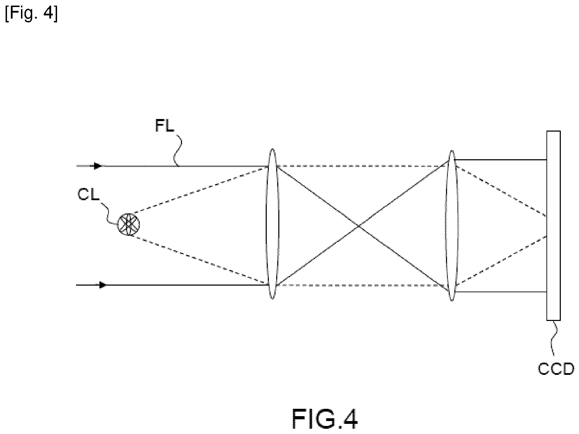

Une première méthode illustrée figure 4 consiste à éclairer le nuage à analyser par un faisceau laser FL résonant (excitation via une transition optique) et d'imager le nuage sur un détecteur. Chaque niveau absorbe différemment le rayonnement et on obtient une image par absorption du nuage en détectant sur une caméra CCD la transmission du faisceau laser FL traversant les atomes. On remonte alors au nombre d'atomes dans chaque niveau.

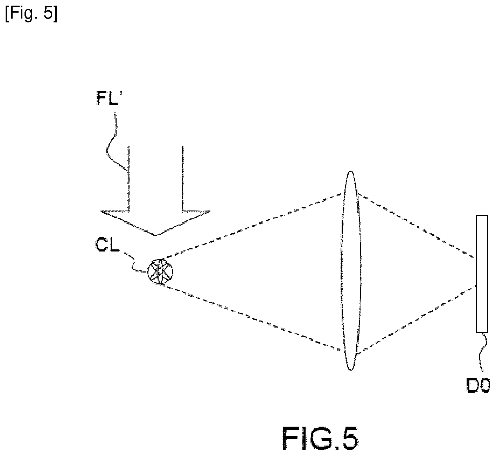

Dans une deuxième méthode illustrée figure 5 on soumet le nuage atomique à une excitation laser résonnante en l'éclairant avec un faisceau FL' (excitation via une transition optique) et on recueille sur une photodiode D0 un signal de fluorescence émis par le nuage, fonction du nombre d'atomes dans le niveau atomique qui fluoresce.

Dans les deux cas on excite les atomes par exemple dans l'état la> à un niveau optique très éloigné des niveaux la> et |b> (de plusieurs THz) et on mesure alors le nombre d'atomes dans l'état la>, ce qui les fait disparaître. De même pour l'état |b>. La mesure de la population respective de chaque niveau se fait donc par l'intermédiaire de ce niveau optique (typiquement 780 nm).

Ces deux méthodes présentent un inconvénient majeur : elles sont destructives. Cela signifie que pour recommencer un cycle de mesure, un nouveau nuage d'atomes froids doit être préparé. Cela induit des temps morts dans la mesure de la grandeur physique. Ces temps morts limitent la stabilité du capteur (Effet Dick) et limitent la bande passante du capteur (typiquement 1 Hz).

Par ailleurs ces deux méthodes nécessitent des systèmes optiques complexes et très volumineux pour détecter efficacement les atomes. Ils ne sont pas compatibles avec le développement de capteurs inertiels compacts et de faible consommation de puissance.

La publication de Bernd Meyer et al « Dynamical low-noise microwave source for cold atom experiments » Cornell University Library, 24 mars 2020, décrit la génération d'une source microonde à bas bruit pour des interféromètres atomique.

Un but de la présente invention est de remédier aux inconvénients précités en proposant une méthode de mesure d'une grandeur représentative de la population d'atomes dans un état atomique prédéterminé, les atomes étant localisés dans un nuage d'atomes froids, de manière non destructive et non optique.

## DESCRIPTION DE L'INVENTION

La présente invention concerne un dispositif de mesure d'une grandeur représentative d'une population d'atomes froids occupant un niveau atomique prédéterminé, lesdits atomes froids étant localisés dans un nuage d'atomes froids à à analyser selon la revendication 1.

Selon un mode de réalisation ladite grandeur représentative est proportionnelle à ladite population.

Selon une variante le détecteur est configuré pour détecter des puissances réfléchies atomique et référence, ladite grandeur représentative étant déterminée à partir desdites puissance atomiques et de référence.

Selon une autre variante le détecteur est configuré pour détecter des amplitudes réfléchies atomique et référence, ladite grandeur représentative associée étant déterminée à partir desdites amplitudes, et/ou pour détecter des phases atomique et référence, ladite grandeur représentative associée étant déterminée à partir desdites phases.

Préférentiellement le dispositif de séparation est configuré pour extraire une fraction du signal incident et le détecteur est configuré pour détecter ladite fraction du signal incident et pour mesurer lesdites phases atomique et référence.

Préférentiellement le guide microonde et l'antenne sont intégrés sur une puce à atomes.

Selon un mode de réalisation la fréquence signal fs est telle que :

$$fs \geq fT + f0/2$$

avec fT fréquence de la transition de détection la plus élevée parmi les transitions possibles et f0 fréquence de séparation de deux sous niveaux Zeeman desdits atomes froids.

Selon un autre aspect l'invention concerne un capteur à atome froid selon la revendication 8.

Préférentiellement le guide microonde et ladite antenne du dispositif de mesure sont intégrés sur ladite puce à atomes et dans lequel ladite antenne est localisée à proximité d'une position du nuage à atome froid à analyser.

Selon un mode de réalisation le dispositif de séparation du dispositif de mesures est également intégré sur ladite puce à atomes.

Selon un mode de réalisation le capteur selon l'invention est configuré pour générer un premier et un deuxième nuages à atomes froids à analyser en mouvement, et comprenant un premier et un deuxième dispositifs de mesure comprenant respectivement un premier et un deuxième guide d'onde et une première et une deuxième antenne intégrés sur ladite puce, le premier dispositif de mesure étant configuré pour mesurer la première grandeur représentative du premier nuage et le deuxième dispositif de mesure étant configuré pour mesurer la deuxième grandeur représentative du deuxième nuage.

Selon encore un autre aspect l'invention concerne un procédé de mesure d'une grandeur représentative d'une population d'atomes froids occupant un niveau atomique prédéterminé, lesdits atomes froids étant localisés dans un nuage d'atomes froids à analyser selon la revendication 12.

La description suivante présente plusieurs exemples de réalisation du dispositif de l'invention : ces exemples sont non limitatifs de la portée de l'invention. Ces exemples de réalisation présentent à la fois les caractéristiques essentielles de l'invention ainsi que des caractéristiques additionnelles liées aux modes de réalisation considérés.

L'invention sera mieux comprise et d'autres caractéristiques, buts et avantages de celle-ci apparaîtront au cours de la description détaillée qui va suivre et en regard des dessins annexés donnés à titre d'exemples non limitatifs et sur lesquels :

[Fig 1] La figure 1 déjà citée illustre une puce à atomes pour capteur inertiel de type accéléromètre/gyromètre.

[Fig 2] La figure 2 déjà citée illustre les différents sous niveaux Zeeman du Rubidium 87.

[Fig 3] La figure 3 déjà citée illustre les principales étapes mise en oeuvre par un capteur à atomes froids.

[Fig 4] La figure 4 déjà citée illustre une première méthode de détection optique.

[Fig 5] La figure 5 déjà citée illustre une deuxième méthode de détection optique.

[Fig 6] La figure 6 illustre un dispositif de mesure d'une grandeur représentative de la population d'atomes froids selon l'invention.

[Fig 7] La figure 7 illustre la variation de la grandeur représentative $\Gamma_A$ de la population en fonction de la population.

[Fig 8] La figure 8 illustre de variation de la valeur absolue de la grandeur représentative $\Gamma_A$ obtenue en interrogeant un nuage à atomes froids en Rubidium 87 en fonction de la fréquence d'interrogation.

[Fig 9] La figure 9 décrit les niveaux Zeeman du Rubidium 87 et le décalage de fréquence à ajouter à la transition de détection afin de déterminer la fréquence signal.

[Fig 10] La figure 10 illustre une variante du dispositif de séparation permettant l'extraction d'une fraction du signal incident.

[Fig 11] La figure 11 illustre un exemple de dispositif de séparation intégré sur la puce à atomes et couplé à un guide microonde coplanaire à 3 fils également intégré.

[Fig 12] La figure 12 illustre un premier exemple de capteur inertiel selon l'invention, de type gyromètre.

[Fig 13] La figure 13 illustre un deuxième exemple de capteur inertiel selon l'invention, de type accéléromètre.

[Fig 14] La figure 14 illustre un mode de réalisation du capteur décrit figure 13 comprenant deux dispositifs de séparation tels que décrit figure 11, permettant un accès à la mesure de la phase des signaux réfléchis atomique et référence.

**DESCRIPTION DETAILLEE DE L'INVENTION**

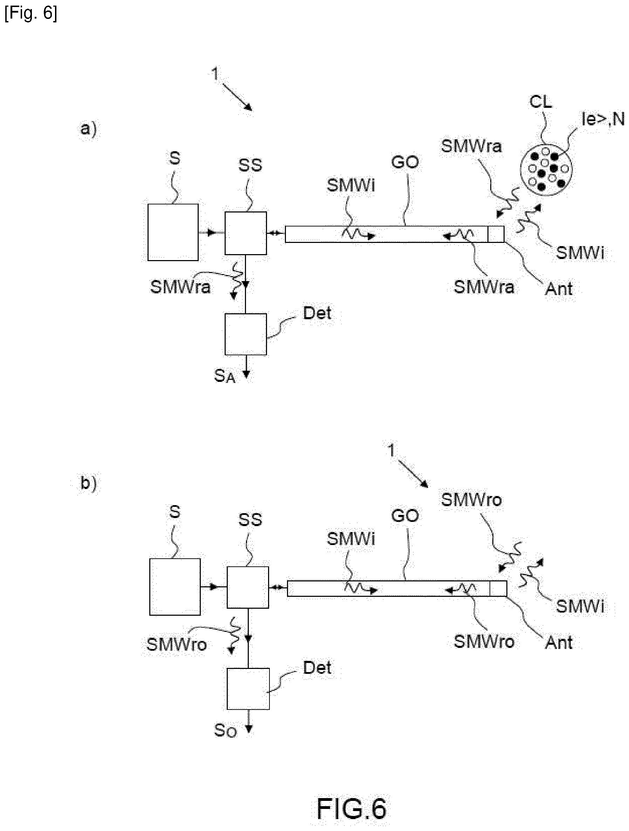

Le dispositif 1 de mesure d'une grandeur représentative de la population N d'atomes froids occupant un niveau atomique prédéterminé, dénommé le>, et localisés dans un nuage CL d'atomes froids à analyser, est illustré figure 6. Le dispositif 1 comprend une source microonde S configurée pour générer un signal incident SMWi à une fréquence signal prédéterminée fs, un guide microonde GO couplé à la source S et configuré pour propager le signal incident microonde (MW pour « microwave » en anglais) et une antenne Ant configurée pour émettre le signal incident vers le nuage d'atomes froids à analyser CL. Selon un mode de réalisation préféré c'est l'extrémité du guide GO qui fait office d'antenne (forme de l'extrémité du guide, manière de connecter les fils à cette extrémité). Selon un autre mode de réalisation l'antenne Ant est un composant additionnel couplé au guide microonde GO. Ainsi le terme antenne fait référence soit à la partie émettrice du guide GO soit au composant additionnel jouant ce rôle dite lorsqu'il existe.

L'antenne Ant et le guide microonde GO sont également aptes à récupérer un signal réfléchi atomique SMWra provenant d'une réflexion du signal incident par ledit nuage et son environnement, et qui se propage dans le guide d'onde en sens inverse du signal incident. Ce signal réfléchi est issu de la modification de l'impédance de rayonnement provoquée par la présence du nuage atomique. En effet la puissance microonde émise par l'antenne dépend du milieu dans lequel ladite antenne rayonne. Cette dépendance est définie par l'impédance de rayonnement du milieu et elle est propre à celui-ci. Ainsi, toute la puissance microonde du signal incident SMWi envoyé vers l'antenne à partir la source S n'est pas absorbée par le milieu autour de l'antenne. Une partie de la puissance envoyée est réfléchie et portée par le signal réfléchi atomique SMWra. Ce signal SWMra contient des informations sur le milieu dans lequel ladite antenne rayonne et les inventeurs ont montré et validé qu'en particulier ces informations incluent une grandeur représentative du nombre d'atomes et l'état atomique dans lequel ils se trouvent.

L'origine de l'impédance de rayonnement et donc du signal réfléchi atomique s'explique de la manière suivante. Les atomes sont caractérisés par un moment dipolaire magnétique et, d'une façon très simplifiée, on peut les considérer comme des aimants qui interagissent avec la composante magnétique du champ microonde. Cette interaction dépend de l'état interne des atomes. Dans le cas d'atomes de rubidium 87 ces sont les états magnétiques Zeeman des états hyperfins fondamentaux que l'on peut coupler avec le champ. Ainsi, le champ magnétique microonde de fréquence signal fs, excite le dipôle magnétique d'une transition atomique déterminée T du matériau constituant les atomes, par exemple le Rubidium 87, avec une efficacité qui dépend, entre autre, de l'écart entre la fréquence signal fs et la fréquence de la transition. Ce dipôle magnétique atomique à son tour émet un champ microonde qui une fois capté par l'antenne génère le signal réfléchi atomique SMWra. Les signaux incident SMWi et réfléchi SMWra se superposent dans le guide d'onde GO et donnent lieu à un coefficient de réflexion qui quantifie l'impédance de rayonnement de l'antenne en présence des atomes. L'origine physique de l'impédance de rayonnement est commentée dans la publication « An antenna model forthe Purcell effect » de Alexander E. Krasnok et al, Nature - Scientific Report, aout 2015.

En d'autres termes en présence d'atomes, l'impédance vue par le générateur hyperfréquence S est déterminée par le couplage entre la composante magnétique du champ et le moment magnétique des atomes. Ce couplage est fonction du nombre total d'atomes, de leur état interne, du désaccord entre la fréquence signal (fréquence d'interrogation des atomes) par rapport aux transitions atomiques entre les états hyperfins, la vitesse des atomes, la puissance rayonnée par l'antenne.

Pour accéder à ce signal réfléchi le dispositif selon l'invention comprend également un dispositif de séparation SS couplé au guide microonde GO et configuré pour extraire au moins une partie du signal réfléchi et un détecteur Det configuré pour détecter le signal réfléchi extrait par le dispositif de séparation.

En plus du signal réfléchi atomique en présence du nuage d'atome SMWa, on détecte également de la même manière le signal réfléchi par l'environnement en l'absence dudit nuage CL, et ce signal est dénommé signal réfléchi référence SMWr0. Les inventeurs ont montré qu'une grandeur représentative de la population d'atomes froids N dudit niveau atomique prédéterminé est obtenue à partir d'une valeur détectée $P_A$ du signal réfléchi atomique et d'une valeur détectée $P_0$ du signal réfléchi référence. La population N d'atomes est ainsi reliée aux impédances de rayonnement avec et sans la présence des atomes.

Pour un fonctionnement optimum du dispositif les atomes du nuage sont placés dans le champ proche de l'antenne, à une distance qui permet l'observation du signal réfléchi avec un bon rapport signal sur bruit déterminé par l'application considérée. Typiquement cette distance est comprise entre quelques microns et 500 $\mu$m.

Le dispositif selon l'invention présente de nombreux avantages par rapport aux dispositifs optiques existant décrit précédemment.

Il permet d'obtenir un signal électrique représentatif du nombre d'atomes dans l'état atomique prédéterminé de manière directe.

Le dispositif selon l'invention peut être utilisé de différente manière en fonction de l'application.

Pour une application du dispositif selon l'invention en spectroscopie, l'obtention directe d'une grandeur représentative du nombre d'atomes sur un niveau donné, en fonction de la fréquence signal fs permet, en faisant varier cette fréquence d'interrogation, de localiser les fréquences des transitions de manière simplifiée (voir plus loin).

Pour une application du dispositif dans des capteurs inertiels et de manière plus générale des interféromètres atomiques, la réalisation de ces systèmes est facilitée par l'intégration d'un dispositif 1 selon l'invention.

La détection est non destructive, permettant la réalisation de plusieurs mesures par exemple inertielles avec le même nuage d'atomes. Ainsi la contribution du temps de préparation (refroidissement) au temps mort de l'interféromètre peut être réduite/supprimée sur une durée équivalente à la durée de vie des échantillons d'atomes froids. Comme expliqué plus haut l'existence de temps morts limite la stabilité du capteur inertiel. Avec des mesures non destructives cette limite est repoussée, permettant par exemple la réalisation d'une navigation inertielle autonome sur des durées relativement longues.

De par leur nature intrinsèque les capteurs inertiels à atomes froids de l'état de la technique ont une bande passante limitée, typiquement à 1 Hz, dû au refroidissement des atomes. La possibilité de réaliser plusieurs mesures non destructrices à la suite, sur un même échantillon d'atomes froids, permise grâce au dispositif de mesure selon l'invention, augmente la bande passante du capteur.

Le dispositif selon l'invention est particulièrement adapté à un système utilisant une puce à atomes (tel que des capteurs inertiels à puce dont un exemple est décrit ci-dessus) dans lequel les atomes à détecter sont ceux refroidis puis manipulés sur les microcircuits de la puce à atomes. Dans ce mode de réalisation le guide microonde GO et l'antenne Ant du dispositif selon l'invention sont intégrés sur la puce à atomes.

Comme expliqué plus haut, les atomes froids sont d'abord préparés dans un état fondamental hyperfin donné, puis sont guidés ou piégés sur le microcircuit à une distance h et de manière à réaliser un interféromètre à atomes pour mesurer une grandeur inertielle. Le guide d'onde GO est ici préférentiellement un guide d'onde hyperfréquence coplanaire microfabriqué sur la puce. Le guide est formé par un minimum de trois microfils séparés entre eux d'une distance donnée d. Les microfils peuvent suivre une ligne droite, incurvée ou tout autre motif nécessaire à l'application envisagée. Pour le cas de la configuration minimale à trois fils, les deux fils de l'extérieur sont connectés à la masse de la source hyperfréquence et le fil central porte le signal actif.

Mais on peut également utiliser d'autres types de guides d'onde, en particulier des guides d'onde dont la fabrication est compatible avec les techniques de microfabrication par dépôt ou par gravure, telle une ligne à microruban.

Le procédé de fabrication du guide d'onde GO est essentiellement le même que celui employé pour la fabrication du microcircuit MC, ce qui simplifie la fabrication du capteur.

Le guide GO est typiquement réalisé dans un plan de la puce différent de celui du microcircuit générant le guide magnétique G, ce qui permet d'approcher au plus près l'antenne du nuage, par exemple en localisant l'antenne (qui peut être l'extrémité du guide GO) à l'aplomb de la trajectoire des nuages.

La détection opérée par un dispositif selon l'invention intégré sur une puce permet de réduire considérablement l'encombrement du capteur inertiel. On s'affranchit alors de systèmes optiques complexes, et souvent relativement volumineux, pour détecter les atomes efficacement. On s'affranchit également des caméras CCD dont la taille importante est déterminée par l'électronique nécessaire à la mise en forme de signaux (conversion de l'intensité pixel en tension électrique). Cette réduction drastique de l'encombrement associé à une simplification de la fabrication ouvre la voie d'une production industrielle de ce type de capteur/interféromètre.

Le caractère intégré du dispositif de mesure/détection selon l'invention permet une bonne reproductibilité d'un dispositif à l'autre.

En modélisant les interactions entre le signal incident et le nuage atomique les inventeurs ont montré que le nombre d'atomes dans le niveau interrogé était fonction d'une grandeur représentative $\Gamma_A$ définie comme suit :

$$\Gamma_A = \frac{S_A - S_0}{S_A + S_0} \quad (5)$$

avec $S_A$ valeur détectée du signal réfléchi atomique et $S_0$ valeur détectée du signal réfléchi référence. Cette grandeur $\Gamma_A$ est dénommé coefficient de réflexion atomique.

Selon un premier mode de réalisation le signal détecté est la puissance microonde P.

Dans ce cas le coefficient $\Gamma_A$ s'écrit $\Gamma_{AP}$ est réel et s'écrit :

$$\Gamma_{AP} = \frac{P_A - P_0}{P_A + P_0} \quad (6)$$

Avec $P_A$ puissance réfléchie atomique et $P_0$ puissance réfléchie référence.

Le détecteur Det est ici un détecteur de puissance microonde.

Selon un deuxième mode de réalisation le signal détecté est une tension électrique (amplitude et phase du signal électrique) Le guide d'onde GO propage un signal microonde et donc les tensions électriques $V_A$ et $V_0$ peuvent

s'écrire comme :

$$V_{A=} V_{A0} \cos(w\, t + \varphi_A)$$

et

$$V_{0=} V_{00} \cos(w\, t + \varphi_0).$$

Avec :

$V_{A0}$ amplitude réfléchie atomique,
$V_{00}$ amplitude réfléchie référence,
$\varphi_A$ phase relative entre le signal incident et le signal réfléchi atomique, dénommée phase atomique, et
$\varphi_0$ phase relative entre le signal incident et le signal réfléchi référence, dénommée phase référence.

Ces tensions $V_A$ et $V_O$ peuvent être représentés par des vecteurs de phase (phasors).

On définit alors $\Gamma_{AV}$ et $\Gamma_{A\varphi}$ grandeur représentatives respectivement associées à la mesure de l'amplitude et de la phase :

$$\Gamma_{AV} = \frac{V_{A0} - V_{00}}{V_{A0} + V_{00}} \qquad (7)$$

$$\Gamma_{A\varphi} = \frac{\varphi_A - \varphi_0}{\varphi_A + \varphi_0} \qquad (8)$$

Le détecteur Det est ici configuré pour détecter les amplitudes réfléchies atomique $V_{A0}$ et référence $V_{00}$, la grandeur représentative associée $\Gamma_{AV}$ étant déterminée à partir desdites amplitudes $V_{A0}$ et $V_{00}$, et/ou pour détecter les phases atomique $\varphi_A$ et référence $\varphi_0$, la grandeur représentative associée $\Gamma_{A\varphi}$ étant déterminée à partir desdites phases $\varphi_A$ et $\varphi_0$.

Un détecteur Det permettant la mesure de l'amplitude et de la phase des signaux microonde détectés (atomique ou référence) est un analyseur vectoriel de réseaux ou un détecteur phase-amplitude (voir plus loin).

Une mesure simultanée de $\Gamma_{AV}$ et de $\Gamma_{A\varphi}$ permet d'obtenir deux valeurs de la grandeur caractéristique $\Gamma_A$ , ce qui améliore la précision avec laquelle cette grandeur est déterminée.

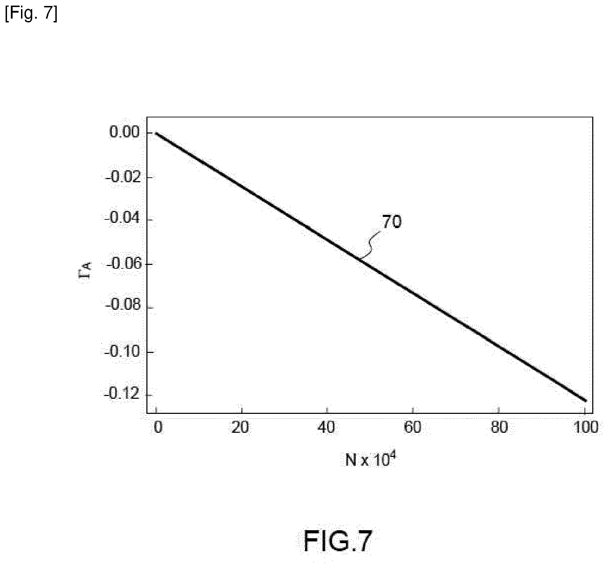

Les inventeurs ont également montré qu'il existe en première approximation d'une relation de proportionnalité entre la grandeur représentative $\Gamma_A$ définie formule (6) (mais aussi formules (7) et (8) car il s'agit de la même grandeur mesurée de trois manière différente) et la population N. La courbe 70 de la figure 7 décrit un exemple de variation de valeur $\Gamma_A$ en fonction de N. On a :

$$\Gamma_A = K.\, N \qquad (9)$$

avec K facteur de proportionnalité.

La courbe 70 est une courbe théorique calculée avec la puissance comme grandeur détectée. Les conditions d'intérêt sont : taille du nuage = 1 mm ; température du nuage = 2$\mu$K ; transition Tn |F=2, m_F=+2> vers |F=1, m_F=+1>, fréquence signal fs=0.999 $f_{Tn}$ = 0.999.($f_n$+3f0).

Le facteur de proportionnalité K est fonction de la fréquence signal choisie fs, la transition atomique couplée par cette fréquence signal, l'espèce atomique, le facteur de forme du champ proche de l'antenne (dépend de la géométrie choisie de l'antenne).

Lorsque l'on souhaite remonter à la valeur exacte de la population N, ce facteur K peut être déterminé, pour un dispositif selon l'invention donné, une fois pour toute à titre de calibration.

Mais dans plusieurs applications la valeur exacte de la population n'est pas nécessaire, et l'information pertinente est extraite à partir de la grandeur représentative de la population N, $\Gamma_A$.

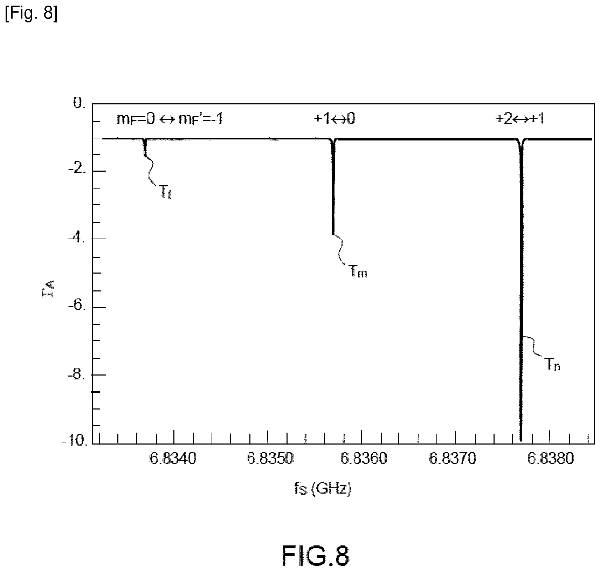

En spectroscopie l'information pertinente peut être déduite de la variation de $\Gamma_A$ en fonction de la fréquence d'interrogation fs. Un exemple de variation de $\Gamma_A$ (définie par la formule (6)) obtenue en interrogeant un nuage à atomes froids en Rubidium 87 sur un ensemble de fréquences d'interrogation fs, est illustré figure 8 (courbe 80). Le coefficient $\Gamma_A$ est déterminé à partir des puissances réfléchies atomique et référence mesurées par le détecteur Det. Pour cette courbe le nuage comprend $10^4$ atomes, et la distance du nuage à la puce à atomes est h=5$\mu$m.

On constate que les transitions bien connues de Rubidium 87 Tl, Tm et Tn (voir figure 2) apparaissent nettement et que leurs fréquences respectives sont identifiées. Pour une valeur de la fréquence fs égale à la fréquence d'une transition connue, la valeur de $\Gamma_A$ est modifiée : on a bien une sensibilité à la fréquence incidente du coefficient de réflexion atomique $\Gamma_A$.

Pour une application de type capteur inertiel il n'est pas non plus nécessaire de remonter à la valeur exacte de la population. Lorsque l'on doit analyser deux nuages CL1 et CL2 on détermine une grandeur $\Gamma_{A1}$ pour la population N1 du niveau atomique la> et une grandeur $\Gamma_{A2}$ pour la population N2 du niveau atomique |b>.

On utilise pour cela préférentiellement deux dispositifs de mesure selon l'invention (voir plus loin). Puisqu'il existe un facteur de proportionnalité K entre N et $\Gamma_A$, dans les formules (3) et (4) exprimant les probabilités d'occupation celui-ci se simplifie entre numérateur et dénominateur et prob1 et prob2 se déduisent directement de $\Gamma_{A1}$ et $\Gamma_{A2}$ :

$$Prob_1 = \frac{\Gamma_{A1}}{\Gamma_{A1}+\Gamma_{A2}} \qquad (10)$$

$$Prob_2 = \frac{\Gamma_{A2}}{\Gamma_{A1}+\Gamma_{A2}} \qquad (11)$$

Lorsque l'on a deux nuages à analyser CL1 et CL2 en propagation libre, la détection effectuée par le dispositif selon l'invention s'effectue préférentiellement selon le type « temps de vol ». L'endroit et l'instant de la recombinaison n'est pas l'endroit et moment de la détection. Le nuage à analyser se déplace, s'approche du détecteur, passe devant (maximum de détection) et s'éloigne. L'instant optimal de détection n'est pas facile à déterminer. Dans ce cas les signaux réfléchis atomique et référence sont détectés en fonction du temps sur un intervalle de temps déterminé $\Delta t$ couvrant, pour la détection du signal réfléchi atomique, le passage du nuage d'atomes à proximité de l'antenne. On mesure alors une intégrale du signal atomique et référence.

Lorsque la recombinaison s'opère sur un nuage piégé qui n'est plus en mouvement (par exemple le capteur décrit dans le document WO2017089489 précité) la mesure des deux grandeurs représentatives $\Gamma_{A1}$ et $\Gamma_{A2}$ peut s'effectuer avec un seul dispositif selon l'invention à deux instants différents. L'antenne Ant du dispositif doit être positionnée aussi près que possible de la position du nuage piégé à analyser.

Dans l'application interféromètre et lorsque $\Gamma_{AP}$ est mesuré, on peut choisir la fréquence d'interrogation fs de différentes manières en fonction de l'objectif de la mesure.

Lorsque l'on souhaite une mesure présentant un maximum de rapport signal sur bruit, on choisit la fréquence signal fs à résonance avec une transition atomique donnée (haut d'un pic de la figure 8). Le signal est alors important mais cette configuration perturbe au maximum les populations N1 et N2, ce qui ne permettra pas une réutilisation des atomes pour des mesures successives.

Lorsque l'on souhaite diminuer la destructivité de la mesure on se positionne à une fréquence fs plus éloignée de la résonnance. On entend par destructivité de la mesure le changement d'état Zeeman des atomes suite à l'application du signal de détection à la fréquence fs, c'est-à-dire, la modification du nombre d'atomes N1 ou N2 (application interféromètre).

Un intérêt de mesurer $\Gamma_{AV}$ et/ou $\Gamma_{A\varphi}$ plutôt que $\Gamma_{AP}$ est de réaliser une mesure à la fois peu destructive et sensible. Pour cela la fréquence signal est choisie de manière à éviter les résonances et à se placer à mi-hauteur d'un pic de transition (figure 8). Cette configuration produit un bon rapport signal sur bruit avec une perturbation minimal de populations.

Ainsi le choix de la fréquence signal fs à laquelle on interroge le nuage atomique à analyser CL dépend de l'application et du type de capteur considéré.

Pour une application du dispositif selon l'invention en spectroscopie, on balaye cette fréquence sur une plage donnée pour identifier les transitions (voir figure 8).

Pour une application capteur inertiel et lorsqu'une mesure à faible destructivité est recherchée, pour pouvoir réutiliser les atomes, le choix de la fréquence fs dépend de l'état atomique à mesurer le> et des transitions permises (dite $\sigma$+), via le choix d'un niveau de détection |d> associé à le>.

Par exemple :

Pour |e>=|F=2, $m_F$ = +2> on choisit |d>=|F=1, $m_F$ = +1> (transition Tn de la figure 2).

Pour |e>=|F=2, $m_F$ = +1> on choisit |d>=|F=1, $m_F$ = 0> (transition Tm de la figure 2).

Pour |e>=|F=2, $m_F$ = 0> on choisit |d>=|F=1, $m_F$ = -1> (transition Tl de la figure 2).

Comme expliqué plus haut la fréquence fs n'est pas dans ce cas égale à la fréquence de la transition utilisée pour la détection (résonnance). On s'en éloigne suffisamment mais pas trop pour conserver un signal réfléchi détectable. Il s'agit de trouver un compromis entre destructivité et sensibilité de la mesure. La fréquence fs doit dans tous les cas être supérieure à la fréquence de la transition de détection la plus élevée parmi les transitions possibles, dénommée $f_T$, afin d'éviter le transfert d'atomes d'un état hyperfin à un autre. Elle doit vérifier la relation :

$$fs \geq fT + f0/2 \quad (12)$$

avec f0 fréquence de séparation de deux sous niveaux Zeeman desdits atomes froids.

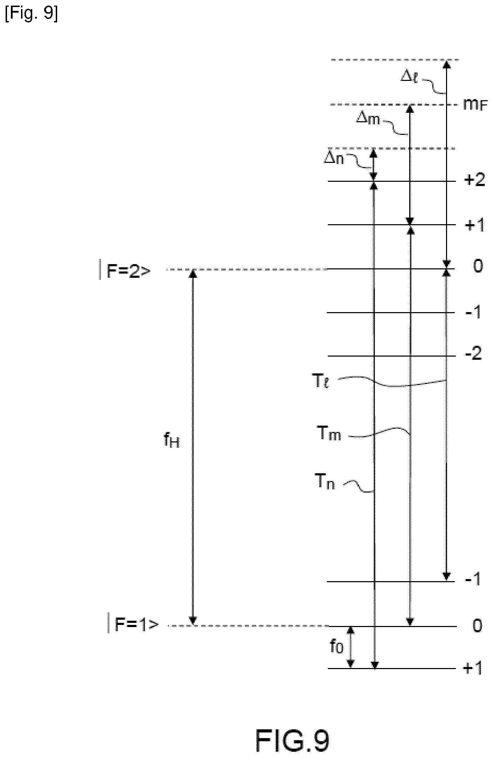

Afin de respecter cette relation la figure 9 décrit le décalage de fréquence $\Delta j$ à ajouter à la transition de détection associée Tj pour vérifier la relation (12).

Pour la transition Tn (mesure de le> = |F=2, $m_F$ = +2>) qui est la transition la plus élevée, l'écart $\Delta n \geq f0/2$.

Pour la transition Tm,

$$\Delta m \geq 2.f0 + f0/2 \, ,$$

Pour Tl

$$\Delta l \geq 4.f0 + f0/2$$

Ainsi la condition sur le $\Delta$ dépend du niveau de détection |d> choisi.

La fréquence fs peut être déterminée par une étape de calibration dans laquelle on fait varier fs, on observe les modifications résonnantes de $\Gamma_A$ en fonction de fs et on identifie quelle fréquence d'interrogation présente le meilleur compromis en fonction des performances de mesure souhaitées. Cette calibration permet également de de caractériser la destructivité de la détection.

Pour une application capteur inertiel on doit mesurer deux grandeurs $\Gamma_{A1}$ et $\Gamma_{A2}$ représentatives respectivement de N1 et N2, associés aux deux états atomiques la> et |b> à analyser. Pour l'exemple du capteur de la figure 1, les deux états la> et |b> à analyser (respectivement peuplés de N1 et N2 atomes) sont (voir précédemment) :

$$|a> = |F=2, mF=+2 ; v1=+v> ; |b> = |F=2, mF=+2 ; v2=-v>.$$

Les états la> et |b> sont différentiés seulement en vitesse. L'état de détection choisi est donc |d>=|F=1, $m_F$ = +1> (transition Tn de fréquence fn de la figure 2) et la fréquence fs=fn+f0/2. La discrimination s'opère par la vitesse uniquement, et donc par la position des atomes par rapport à l'antenne.

On voit que dans le dispositif selon l'invention l'interrogation pour la détection s'effectue avec des fréquences microonde, contrairement à l'état de la technique qui utilise des fréquences optiques. Ceci permet d'avoir le détecteur intégré directement sur la puce à atomes et en plus, d'avoir un signal électrique correspondant aux populations des états atomiques de l'interféromètre.

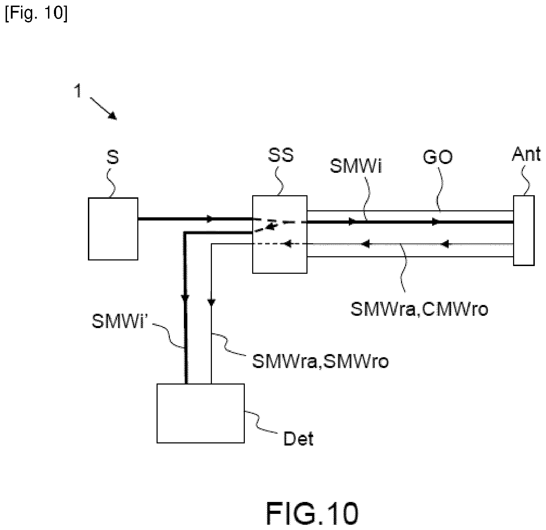

La figure 10 illustre une variante du dispositif 1 selon l'invention permettant de mesurer les phases atomique et référence. Pour cela le dispositif de séparation SS est configuré pour extraire une fraction SMWi' du signal incident et le détecteur Det est configuré pour détecter la fraction du signal incident et ainsi mesurer la phase entre le signal incident et le signal réfléchi atomique (phase atomique $\varphi_A$), et la phase entre le signal incident et le signal réfléchi référence (phase référence $\varphi_0$).

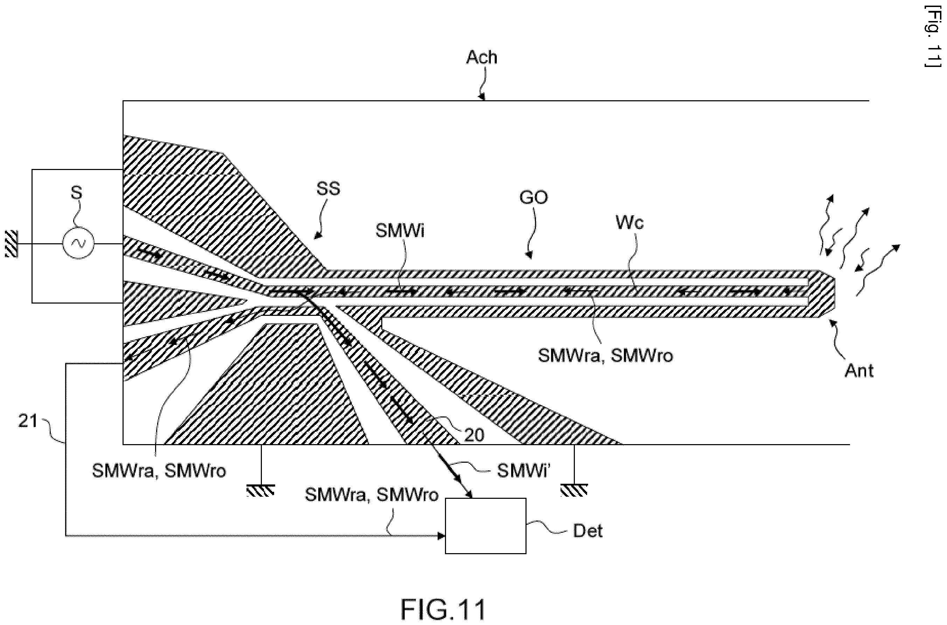

Un exemple de dispositif de séparation SS intégré sur la puce Ach et couplé à un guide microonde coplanaire à 3 fils également intégré, permettant la mesure de l'amplitude et de la phase des signaux réfléchis, est illustré figure 11. Le fil central WC porteur du signal incident et du signal réfléchi est couplé à un fil 20 configuré pour d'une part prélever la fraction SMWI' du signal incident et le diriger vers le détecteur Det et d'autre part diriger le signal réfléchi vers le détecteur via une liaison 21. Ce dispositif de séparation fonctionne comme un coupleur microonde bidirectionnel optimisé autour de la fréquence $f_H$ (très proches de fs).

Le détecteur Det est ici un analyseur vectoriel de réseaux ou un détecteur phase-amplitude permettant la mesure de l'amplitude et de la phase entre le signal incident et le signal réfléchi (atomique ou référence).

Selon un autre aspect l'invention concerne un capteur à atomes froids CAS intégrant au moins un dispositif de mesure selon l'invention. Il peut s'agir de tout type de capteur basé sur l'utilisation d'un nuage d'atomes froids contenant une information concernant la grandeur physique à mesurer codée par une population d'atomes dans un niveau atomique déterminé, et qui nécessite donc une mesure d'une grandeur représentative de cette population.

Selon une variante le capteur CAS selon l'invention comprend une puce à atomes Ach, et préférentiellement l'antenne Ant, le guide GO et le dispositif de séparation SS sont intégrés sur la puce à atomes Ach.

Des capteurs inertiel à puce à atomes ont été décrits dans l'état de la technique.

Le capteur CAS selon cette variante de l'invention comprend une puce à atomes Ach comprenant un microcircuit configuré pour générer un guide magnétique G et une source d'atomes AS, la puce à atomes et la source d'atomes étant placés dans une enceinte à vide.

Le capteur est configuré pour générer un nuage à atomes froids initial comprenant des atomes présentant un premier niveau atomique la> et un deuxième niveau atomique |b>, pour générer et le cas échéant déplacer, en sens inverse selon une trajectoire prédéterminée, un nuage d'atome froids présentant le premier niveau atomique et un nuage d'atomes froids présentant le deuxième niveau atomique, et pour recombiner lesdits nuages d'atomes froids, de manière à générer au moins un nuage à atomes froids à analyser : un seul nuage CL piégé pour le capteur décrit dans le document WO 2017089489 ; deux nuages CL1 et CL2 en propagation libre pour le capteur de la figure 1.

Le capteur à atomes froids comprend en outre au moins un dispositif de mesure 1 selon l'invention configuré pour mesurer une première grandeur représentative $\Gamma_{A1}$ de la population N1 du premier niveau atomique la> et une deuxième grandeur représentative $\Gamma_{A2}$ la population N2 du deuxième niveau atomique |b>. Une grandeur physique, telle une grandeur inertielle, est déterminée à partir des première et deuxième grandeurs représentatives $\Gamma_{A1}$ et $\Gamma_{A2}$. Pour cela les mesures de $\Gamma_{A1}$ et $\Gamma_{A2}$ sont réalisés séquentiellement dans le temps par le dispositif 1.

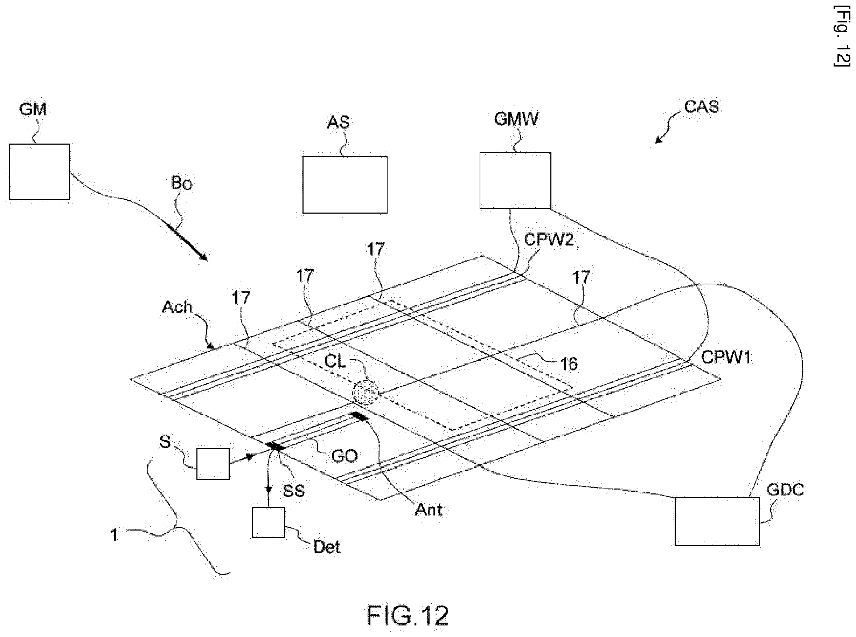

La figure 12 illustre un premier exemple de capteur inertiel selon l'invention, de type gyromètre, dont le principe de fonctionnement est décrit dans le document WO 2017089489. Le microcircuit comprend ici deux guides microonde coplanaires CPW1 et CPW2 (alimentés par un générateur GMW) et plusieurs fils conducteurs 17 (alimentés par des générateurs de courant ou de tension continue GDC), qui permettent le guidage et le déplacement des nuages sur une trajectoire sensiblement rectangulaire 16. Le dispositif selon l'invention est intégré au capteur, avec l'antenne Ant, le guide GO et le dispositif de séparation SS intégrés sur la puce à atomes Ach, dans un plan différent du plan intégrant les guides CPW1 et CPW2 et du plan intégrant les fils 17. L'antenne Ant est localisée à proximité et aussi près que possible du nuage d'atomes froids à analyser CL, typiquement à l'aplomb de la position de CL.

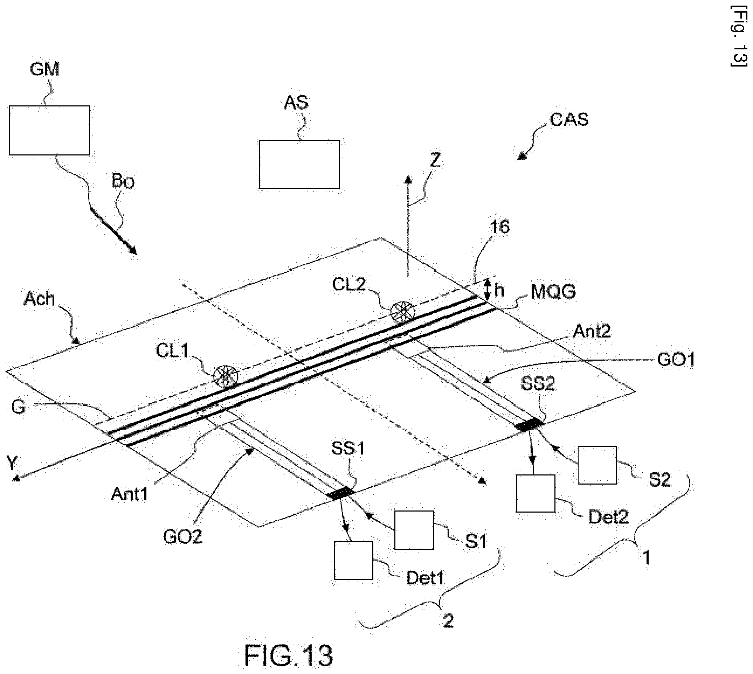

La figure 13 illustre un second exemple de capteur inertiel CAS selon l'invention tel que décrit figure 1, de type accéléromètre. Le microcircuit comprend ici un quadrupôle magnétique. La trajectoire des deux nuages est rectiligne selon l'axe Y et les deux nuages CL1 et CL2 à analyser sont en mouvement (propagation libre) pendant et après la recombinaison. Le capteur comprend un premier dispositif de mesure selon l'invention 1et un deuxième dispositif de mesure selon l'invention 2. Le premier dispositif 1 comprend une première source microonde S1, un premier guide microonde GO1, une première antenne Ant1, un premier dispositif séparateur SS1 (tous trois intégrés sur la puce Ach) et un premier détecteur D1 et est configuré pour mesurer la première grandeur représentative $\Gamma_{A1}$ en analysant le nuage CL1. Le deuxième dispositif 2 comprend une source microonde S2, un deuxième guide microonde GO2, une deuxième antenne Ant2, un deuxième dispositif séparateur SS2 (tous trois également intégrés sur la puce Ach) et un deuxième détecteur D2 et est configuré pour mesurer la deuxième grandeur représentative $\Gamma_{A2}$ en analysant le nuage CL2. Les mesures de $\Gamma_{A1}$ et $\Gamma_{A2}$ s'effectuent alors en parallèle avec les deux dispositifs 1 et 2. Préférentiellement les antennes sont disposées symétriquement par rapport à l'endroit de l'espace ou s'opère la recombinaison et sont localisées sur la trajectoire 16, et la mesure est de type temps de vol.

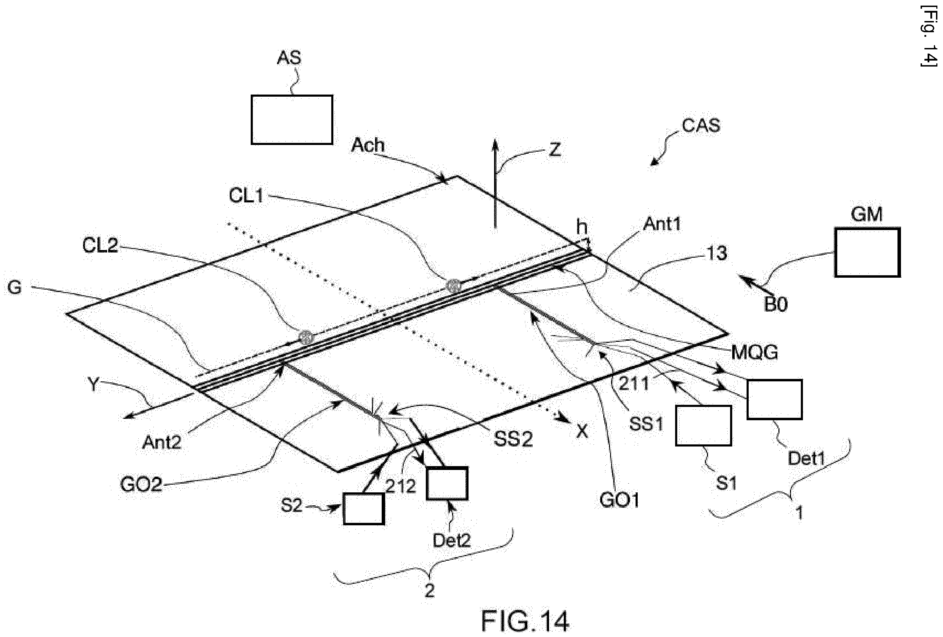

Selon un mode de réalisation illustré figure 14 le capteur décrit figure 13 comprend deux dispositifs de séparation SS1 et SS2 tels que décrit figure 11 (liaisons 211 et 212), permettant un accès à la mesure de la phase des signaux réfléchis atomique et référence.

Selon un autre aspect l'invention concerne un procédé 100 de mesure d'une grandeur représentative d'une population N d'atomes froids occupant un niveau atomique prédéterminé, les atomes froids étant localisés dans un nuage CL d'atomes froids à analyser, le procédé comprenant les étapes consistant à :

A générer un signal incident SMWi microonde à une fréquence signal prédéterminée fs,

B propager dans un guide microonde et émettre ledit signal incident vers ledit nuage d'atomes froids,

C récupérer un signal réfléchi SMWra provenant de la réflexion du signal incident sur ledit nuage et son environnement, dénommé signal réfléchi atomique, et qui se propage dans le guide d'onde en sens inverse du signal incident,

D extraire au moins une partie du signal réfléchi atomique,

E détecter ledit signal réfléchi atomique SMWra extrait,

F préalablement ou postérieurement aux étapes A à E effectuées en présence du nuage d'atomes froids, effectuer les étapes A à E en l'absence dudit nuage, le signal réfléchi, dénommé signal réfléchi référence, provenant alors de la réflexion du signal incident par l'environnement dans lequel évolue le nuage mais en l'absence de celui-ci,

G déterminer ladite grandeur représentative de la population d'atomes froids N du niveau atomique à analyser, à partir d'une valeur détectée $S_A$ du signal réfléchi atomique SMWra, et d'une valeur détectée $S_0$ du signal réfléchi référence SMWr0.

Préférentiellement la mise en oeuvre des étapes A à F en l'absence du nuage sont effectuées postérieurement aux étapes A à F en présence du nuage.

Dans un procédé de mesure d'une grandeur inertielle par un capteur, le procédé de mesure 100 correspond à une étape E5 de détection mise en oeuvre à la place de l'étape E5' décrite dans l'état de la technique et mettant en oeuvre des faisceaux optiques.

## Revendications

1. Dispositif (1, 2) de mesure d'une grandeur ($\Gamma_A$) représentative d'une population (N) d'atomes froids occupant un niveau atomique prédéterminé, lesdits atomes froids étant localisés dans un nuage (CL) d'atomes froids à analyser, le dispositif comprenant :

   - une source microonde (S) configurée pour générer un signal incident (SMWi) à une fréquence signal prédéterminée (fs),
   - un guide microonde (GO) configuré pour propager ledit signal incident et une antenne (Ant) configurée pour émettre ledit signal incident vers ledit nuage d'atomes froids et son environnement,

   le dispositif étant **caractérisé en ce que**:

   ladite antenne et ledit guide microonde étant également aptes à récupérer un signal réfléchi atomique (SMWra) provenant d'une réflexion du signal incident par ledit nuage et son environnement, et qui se propage dans le guide d'onde en sens inverse du signal incident,
   et **en ce que** le dispositif comprend:

   - un dispositif de séparation (SS) couplé au guide microonde et configuré pour extraire au moins une partie du signal réfléchi atomique,
   - un détecteur (Det) configuré pour détecter ledit signal réfléchi atomique extrait par le dispositif de séparation,

   ladite grandeur représentative de la population d'atomes froids (N) dudit niveau atomique prédéterminé étant obtenue à partir d'une valeur détectée ($S_A$) du signal réfléchi atomique (SMWra), et d'une valeur détectée ($S_0$) d'un signal réfléchi par l'environnement en l'absence dudit nuage, dénommé signal réfléchi référence (SMWr0), ladite grandeur représentative ($\Gamma_A$) étant dénommée coefficient de réflexion atomique et définie comme suit:

   $$\Gamma_A = \frac{S_A - S_0}{S_A + S_0}$$

   avec $S_A$ valeur détectée du signal réfléchi atomique
   $S_0$ valeur détectée du signal réfléchi référence

2. Dispositif selon la revendication précédente dans laquelle ladite grandeur représentative est, en première approximation, proportionnelle à ladite population.

3. Dispositif selon l'une des revendications précédentes dans lequel le détecteur est configuré pour détecter des puissances, ladite grandeur représentative ($\Gamma_{AP}$) étant déterminée à partir desdites puissances.

4. Dispositif selon l'une des revendications précédentes dans lequel le détecteur est configuré pour détecter des amplitudes, ladite grandeur représentative associée ($\Gamma_{AV}$) étant déterminée à partir desdites amplitudes, et/ou pour détecter des phases, ladite grandeur représentative associée ($\Gamma_{A\varphi}$) étant déterminée à partir desdites phases.

5. Dispositif selon la revendication précédente dans lequel le dispositif de séparation (SS) est configuré pour extraire une fraction du signal incident et le détecteur (Det) est configuré pour détecter ladite fraction du signal incident et pour mesurer lesdites phases atomique et référence.

6. Dispositif selon l'une des revendications précédentes dans lequel le guide microonde et l'antenne sont intégrés sur une puce à atomes.

7. Dispositif selon l'une des revendications précédente dans lequel la fréquence signal fs est telle que :

$$fs \geq fT + f0/2$$

avec fT fréquence de la transition de détection la plus élevée parmi les transitions possibles,
f0 fréquence de séparation de deux sous niveaux Zeeman desdits atomes froids.

8. Capteur à atome froid (CAS) comprenant :

- une puce à atomes (Ach) comprenant un microcircuit configuré pour générer un guide magnétique et une source d'atomes (AS), la puce à atomes et la source d'atomes étant placés dans une enceinte à vide,
le capteur étant configuré pour générer un nuage à atomes froids initial comprenant des atomes présentant un premier niveau atomique (|a>) et un deuxième niveau atomique (|b>), pour générer et le cas échéant déplacer, en sens inverse selon une trajectoire prédéterminée, un nuage d'atome froids présentant ledit premier niveau atomique et un nuage d'atomes froids présentant ledit deuxième niveau atomique, et pour recombiner lesdits nuages d'atomes froids, de manière à générer au moins un nuage à atomes froids à analyser (CL, CL1, CL2), le capteur à atomes froids comprenant en outre :

- au moins un dispositif de mesure (1) selon l'une des revendications 1 à 7 configuré pour mesurer une première grandeur représentative ($\Gamma_{A1}$) de la population (N1) du premier niveau atomique (|a>) et une deuxième grandeur représentative ($\Gamma_{A2}$) de la population (N2) du deuxième niveau atomique (|b>), une grandeur physique étant déterminée à partir desdites première et deuxième grandeurs représentatives.

9. Capteur selon la revendication précédente dans lequel le guide microonde (GO) et ladite antenne du dispositif de mesure sont intégrés sur ladite puce à atomes et dans lequel ladite antenne (Ant) est localisée à proximité d'une position du nuage à atome froid à analyser.

10. Capteur selon la revendication précédente dans lequel le dispositif de séparation (SS) du dispositif de mesures est également intégré sur ladite puce à atomes.

11. Capteur selon l'une des revendications 9 ou 10 configuré pour générer un premier (CL1) et un deuxième (CL2) nuages à atomes froids à analyser en mouvement, et comprenant un premier (1) et un deuxième (2) dispositifs de mesure comprenant respectivement un premier (GO1) et un deuxième (GO2) guide d'onde et une première (Ant1) et une deuxième (Ant2) antenne intégrés sur ladite puce, le premier dispositif de mesure (1) étant configuré pour mesurer la première grandeur représentative ($\Gamma_{A1}$) du premier nuage et le deuxième dispositif de mesure (2) étant configuré pour mesurer la deuxième grandeur représentative ($\Gamma_{A2}$) du deuxième nuage.

12. Procédé de mesure d'une grandeur représentative d'une population (N) d'atomes froids occupant un niveau atomique prédéterminé, lesdits atomes froids étant localisés dans un nuage (CL) d'atomes froids à analyser,

le procédé comprenant les étapes consistant à :

A générer un signal incident (SMWi) microonde à une fréquence signal prédéterminée (fs),
B propager dans un guide microonde et le cas échéant émettre ledit signal incident vers ledit nuage d'atomes froids,

le procédé étant **caractérisé en ce qu'**il comprend les étapes de:

**C** récupérer un signal réfléchi (SMWra) provenant de la réflexion du signal incident sur ledit nuage et son environnement, dénommé signal réfléchi atomique, et qui se propage dans le guide d'onde en sens inverse du signal incident,

**D** extraire au moins une partie du signal réfléchi atomique,

**E** détecter ledit signal réfléchi atomique (SMWra) extrait,

**F** préalablement ou postérieurement aux étapes A à E effectuées en présence du nuage d'atomes froids, effectuer les étapes A à E en l'absence dudit nuage, le signal réfléchi, dénommé signal réfléchi référence, provenant alors de la réflexion du signal incident par l'environnement dans lequel évolue le nuage mais en l'absence de celui-ci,

**G** déterminer ladite grandeur représentative de la population d'atomes froids (N) du niveau atomique à analyser, à partir d'une valeur ($S_A$) du signal réfléchi atomique (SMWra), et d'une valeur ($S_0$) du signal réfléchi référence (SMWr0), ladite grandeur représentative ($\Gamma_A$) étant dénommée coefficient de réflexion atomique et définie comme suit:

$$\Gamma_A = \frac{S_A - S_0}{S_A + S_0}$$

avec $S_A$ valeur détectée du signal réfléchi atomique
$S_0$ valeur détectée du signal réfléchi référence

**Patentansprüche**

1. Vorrichtung (1, 2) zur Messung einer Größe ($\Gamma_A$), die für eine Population (N) von kalten Atomen repräsentativ ist, die ein vorbestimmtes Atomniveau einnehmen, wobei die kalten Atome in einer Wolke (CL) von zu analysierenden kalten Atomen lokalisiert sind und die Vorrichtung umfasst:

- eine Mikrowellenquelle (S), die so konfiguriert ist, dass sie ein einfallendes Signal (SMWi) mit einer vorbestimmten Signalfrequenz (fs) erzeugt,
- einen Mikrowellenleiter (GO), der so konfiguriert ist, dass er das einfallende Signal ausbreitet, und eine Antenne (Ant), die so konfiguriert ist, dass sie das einfallende Signal zu der Wolke aus kalten Atomen und ihrer Umgebung sendet, wobei die Vorrichtung **dadurch gekennzeichnet ist, dass** die Antenne und der Mikrowellenleiter auch geeignet sind, ein atomares reflektiertes Signal (SMWra) wiederzugewinnen, das aus einer Reflektion des einfallenden Signals durch die Wolke und ihre Umgebung stammt und sich in dem Wellenleiter in umgekehrter Richtung zu dem einfallenden Signal ausbreitet,

und dadurch, dass die Vorrichtung umfasst:

- eine Trennvorrichtung (SS), die mit dem Mikrowellenleiter gekoppelt und konfiguriert ist, um zumindest einen Teil des atomaren reflektierten Signals zu extrahieren,
- einen Detektor (Det), der so konfiguriert ist, dass er das von der Trennvorrichtung extrahierte atomare reflektierte Signal erfasst,

wobei die repräsentative Größe der Population kalter Atome (N) des vorbestimmten Atomniveaus aus einem detektierten Wert ($S_A$) des atomaren reflektierten Signals (SMWra) und einem detektierten Wert ($S_0$) eines von der Umgebung in Abwesenheit der Wolke reflektierten Signals, das als reflektiertes Referenzsignal (SMWrO) bezeichnet wird, erhalten wird, wobei die repräsentative Größe ($\Gamma_A$) als atomarer Reflektionskoeffizient bezeichnet und wie folgt definiert wird:

$$\Gamma A = \frac{SA - S0}{SA + S0}$$

wobei $S_A$ der detektierte Wert des atomaren reflektierten Signals ist

und $S_0$ der detektierte Wert des reflektierten Referenzsignals ist

2. Vorrichtung nach dem vorhergehenden Anspruch, bei der die repräsentative Größe in erster Ordnung zu dieser Population proportional ist.

3. Vorrichtung nach einem der vorhergehenden Ansprüche, bei der der Detektor so konfiguriert ist, dass er Leistungen erfasst, wobei die repräsentative Größe ($\Gamma_{AP}$) anhand der Leistungen bestimmt wird.

4. Vorrichtung nach einem der vorhergehenden Ansprüche, bei der der Detektor so konfiguriert ist, dass er Amplituden erfasst, wobei die zugehörige repräsentative Größe ($\Gamma_{AV}$) anhand der Amplituden bestimmt wird, und/oder Phasen detektiert, wobei die zugehörige repräsentative Größe ($\Gamma_{A\varphi}$) anhand der Phasen bestimmt wird.

5. Vorrichtung nach dem vorhergehenden Anspruch, bei der die Trennvorrichtung (SS) so konfiguriert ist, dass sie einen Bruchteil des einfallenden Signals extrahiert, und der Detektor (Det) so konfiguriert ist, dass er den Bruchteil des einfallenden Signals erfasst und die Atom- und Referenzphasen misst.

6. Vorrichtung nach einem der vorhergehenden Ansprüche, bei der der Mikrowellenleiter und die Antenne auf einem Atomchip integriert sind.

7. Vorrichtung nach einem der vorhergehenden Ansprüche, bei der die Signalfrequenz fs so ist, dass:

$$fs \geq fT + f0/2$$

mit fT als Frequenz des höchsten Detektionsübergangs unter den möglichen Übergängen, wobei f0 die Trennungsfrequenz zweier Zeeman-Sublevels der kalten Atome ist.

8. Kaltatomsensor (CAS) bestehend aus:

- einem Atomchip (Ach) mit einem Mikroschaltkreis, der so konfiguriert ist, dass er eine magnetische Führung und eine Atomquelle (AS) erzeugt, wobei der Atomchip und die Atomquelle in einer Vakuumkammer angeordnet sind,
wobei der Sensor so konfiguriert ist, dass er eine anfängliche kalte Atomwolke erzeugt, die Atome mit einem ersten Atomniveau (la>) und einem zweiten Atomniveau (Ib>) umfasst, um eine kalte Atomwolke mit dem ersten Atomniveau und eine kalte Atomwolke mit dem zweiten Atomniveau zu erzeugen und gegebenenfalls entlang einer vorbestimmten Bahn in entgegengesetzter Richtung zu bewegen, und um die kalten Atomwolken zu rekombinieren, um mindestens eine zu analysierende kalte Atomwolke (CL, CL1, CL2) zu erzeugen, wobei der Kaltatomsensor ferner umfasst:

- mindestens eine Messvorrichtung (1) nach einem der Ansprüche 1 bis 7, die so konfiguriert ist, dass sie eine erste repräsentative Größe ($\Gamma_{A1}$) der Population (N1) des ersten Atomniveaus (la>) und eine zweite repräsentative Größe ($\Gamma_{A2}$) der Population (N2) des zweiten Atomniveaus (Ib>) misst, wobei eine physikalische Größe anhand der ersten und der zweiten repräsentativen Größe bestimmt wird.

9. Sensor nach dem vorhergehenden Anspruch, bei dem der Mikrowellenleiter (GO) und die Antenne der Messvorrichtung auf dem Atomchip integriert sind und bei dem die Antenne (Ant) in der Nähe einer Position der zu analysierenden kalten Atomwolke lokalisiert ist.

10. Sensor nach dem vorhergehenden Anspruch, bei dem die Trennvorrichtung (SS) der Messvorrichtung ebenfalls auf dem Atomchip integriert ist.

11. Sensor nach einem der Ansprüche 9 oder 10, der so konfiguriert ist, dass er eine erste (CL1) und eine zweite (CL2) Wolke aus kalten Atomen erzeugt, die in Bewegung analysiert werden sollen, und der eine erste (1) und eine zweite (2) Messvorrichtung umfasst, die jeweils einen ersten (G01) und einen zweiten (G02) Wellenleiter und eine erste (Ant1) und eine zweite (Ant2) Antenne umfassen, die auf dem Chip integriert sind, wobei die erste Messvorrichtung (1) so konfiguriert ist, dass sie die erste repräsentative Größe ($\Gamma_{A1}$) der ersten Wolke misst, und die zweite Messvorrichtung (2) so konfiguriert ist, dass sie die zweite repräsentative Größe ($\Gamma_{A2}$) der zweiten Wolke misst.

**12.** Verfahren zur Messung einer Größe, die für eine Population (N) kalter Atome repräsentativ ist, die ein vorbestimmtes Atomniveau einnehmen, wobei die kalten Atome in einer Wolke (CL) kalter Atome, die analysiert werden sollen, lokalisiert sind, wobei das Verfahren die folgenden Schritte umfasst:

> **A** Erzeugen eines einfallenden Mikrowellensignals (SMWi) mit einer vorbestimmten Signalfrequenz (fs),
> **B** Ausbreiten in einem Mikrowellenleiter und gegebenenfalls Senden des einfallenden Signals in Richtung der Wolke aus kalten Atomen,

wobei das Verfahren **dadurch gekennzeichnet ist, dass** es die folgenden Schritte umfasst:

> **C** Sammeln eines reflektierten Signals (SMWra), das aus der Reflektion des einfallenden Signals an der Wolke und ihrer Umgebung stammt, das als atomares reflektiertes Signal bezeichnet wird, und das sich im Wellenleiter in umgekehrter Richtung zum einfallenden Signal ausbreitet,
> **D** Extrahieren mindestens eines Teils des atomaren reflektierten Signals,
> **E** Detektieren des extrahierten atomaren reflektierten Signals (SMWra),
> **F** Durchführung vor oder nach den Schritten A bis E, die in Gegenwart der Wolke kalter Atome durchgeführt werden, der Schritte A bis E in Abwesenheit der Wolke, wobei das reflektierte Signal, das als reflektiertes Referenzsignal bezeichnet wird, dann von der Reflektion des einfallenden Signals durch die Umgebung, in der sich die Wolke bewegt, aber in Abwesenheit der Wolke stammt,
> **G** Bestimmen der repräsentativen Größe der Population kalter Atome (N) des zu analysierenden Atomniveaus anhand eines Werts ($S_A$) des atomaren reflektierten Signals (SMWra) und eines Werts ($S_0$) des reflektierten Referenzsignals (SMWrO), wobei die repräsentative Größe ($\Gamma_A$) als atomarer Reflektionskoeffizient bezeichnet wird und wie folgt definiert ist:

$$\Gamma A = \frac{SA - S0}{SA + S0}$$

> mit $S_A$ als erfassten Wert des atomaren reflektierten Signals und
> $S_0$ als erfassten Wert des reflektierten Referenzsignals

### Claims

**1.** A device (1, 2) for measuring a quantity ($\Gamma_A$) representative of a population (N) of cold atoms occupying a predetermined atomic level, said cold atoms being located in a cloud (CL) of cold atoms to be analyzed, the device comprising:

> - a microwave source (S) configured to generate an incident signal (SMWi) at a predetermined signal frequency (fs),
> - a microwave guide (GO) configured to propagate said incident signal and an antenna (Ant) configured to emit said incident signal to said cloud of cold atoms and its environment,

Said device being **characterized in that**:

> said antenna and said microwave guide also being able to recover an atomic reflected signal (SMWra) resulting from a reflection of the incident signal by said cloud and its environment, and which propagates in the waveguide in the opposite direction to the incident signal,
> and **in that** the device comprises:

>> - a splitting device (SS) coupled to the microwave guide and configured to extract at least part of the atomic reflected signal,
>> - a detector (Det) configured to detect said atomic reflected signal extracted by the splitting device,

> said quantity representative of the population of cold atoms (N) of said predetermined atomic level being obtained from a detected value ($S_A$) of the atomic reflected signal (SMWra) and from a detected value ($S_0$) of a signal reflected by the environment in the absence of said cloud, called reference reflected signal (SMWr0), said representative quantity ($\Gamma_A$) being called atomic reflection coefficient and defined as follows:

$$\Gamma_A = \frac{S_A - S_0}{S_A + S_0}$$

where $S_A$ is the detected value of the atomic reflected signal
$S_0$ is the detected value of the reference reflected signal.

2. The device as claimed in the preceding claim, wherein said representative quantity is, as a first approximation, proportional to said population.

3. The device as claimed in one of the preceding claims, wherein the detector is configured to detect powers, said representative quantity (($\Gamma_{AP}$) being determined from said powers.

4. The device as claimed in one of the preceding claims, wherein the detector is configured to detect amplitudes, said associated representative quantity ($\Gamma_{AV}$) being determined from said amplitudes, and/or to detect phases, said associated representative quantity ($\Gamma_{A\varphi}$) being determined from said phases.

5. The device as claimed in the preceding claim, wherein the splitting device (SS) is configured to extract a fraction of the incident signal and the detector (Det) is configured to detect said fraction of the incident signal and to measure said atomic and reference phases.

6. The device as claimed in one of the preceding claims, wherein the microwave guide and the antenna are integrated on an atom chip.

7. The device as claimed in one of the preceding claims, wherein the signal frequency fs is such that:

$$fs \geq fT + f0/2$$

where fT is the frequency of the highest detection transition among the possible transitions,
f0 is the separation frequency of two Zeeman sub-levels of said cold atoms.

8. A cold-atom sensor (CAS) comprising:

   - an atom chip (Ach) comprising a microcircuit configured to generate a magnetic guide and an atom source (AS), the atom chip and the atom source being placed in a vacuum chamber,

   the sensor being configured to generate an initial cloud of cold atoms comprising atoms having a first atomic level (|a>) and a second atomic level (|b>), to generate and where applicable move, in the opposite direction along a predetermined path, a cloud of cold atoms having said first atomic level and a cloud of cold atoms having said second atomic level, and to recombine said clouds of cold atoms, so as to generate at least one cloud of cold atoms (CL, CL1, CL2) to be analyzed, the cold-atom sensor furthermore comprising:

   - at least one measuring device (1) as claimed in one of claims 1 to 7 configured to measure a first quantity ($\Gamma_{A1}$) representative of the population (N1) of the first atomic level (|a>) and a second quantity ($\Gamma_{A2}$) representative of the population (N2) of the second atomic level (|b>), a physical quantity being determined from said first and second representative quantities.

9. The sensor as claimed in the preceding claim, wherein the microwave guide (GO) and said antenna of the measuring device are integrated on said atom chip and wherein said antenna (Ant) is located close to a position of the cloud of cold atoms to be analyzed.

10. The sensor as claimed in the preceding claim, wherein the splitting device (SS) of the measuring device is also integrated on said atom chip.

11. The sensor as claimed in either of claims 9 and 10, configured to generate a first (CL1) and a second (CL2) cloud of cold atoms to be analyzed in motion, and comprising a first (1) and a second (2) measuring device comprising, respectively, a first (GO1) and a second (GO2) waveguide and a first (Ant1) and a second (Ant2) antenna integrated on said chip, the first measuring device (1) being configured to measure the first quantity ($\Gamma_{A1}$) representative of the first cloud and the second measuring device (2) being configured to measure the second quantity ($\Gamma_{A2}$) representative of the second cloud.

12. A method for measuring a quantity representative of a population (N) of cold atoms occupying a predetermined atomic level, said cold atoms being located in a cloud (CL) of cold atoms to be analyzed,

the method comprising the steps of:

**A** generating a microwave incident signal (SMWi) at a predetermined signal frequency (fs),
**B** propagating, in a microwave guide, and, where applicable, emitting said incident signal to said cloud of cold atoms,

the method being **characterized in that** it further comprises the steps of:

**C** recovering a reflected signal (SMWra) resulting from the reflection of the incident signal from said cloud and its environment, called atomic reflected signal, and which propagates in the waveguide in the opposite direction to the incident signal,
**D** extracting at least part of the atomic reflected signal,
**E** detecting said extracted atomic reflected signal (SMWra),
**F** before or after steps A to E performed in the presence of the cloud of cold atoms, performing steps A to E in the absence of said cloud, the reflected signal, called reference reflected signal, then resulting from the reflection of the incident signal by the environment in which the cloud evolves, but in the absence of said cloud,
**G** determining said quantity representative of the population of cold atoms (N) of the atomic level to be analyzed from a value ($S_A$) of the atomic reflected signal (SMWra) and from a value ($S_0$) of the reference reflected signal (SMWr0), said representative quantity ($\Gamma_A$) being called atomic reflection coefficient and defined as follows:

$$\Gamma_A = \frac{S_A - S_0}{S_A + S_0}$$

where $S_A$ is the detected value of the atomic reflected signal
$S_0$ is the detected value of the reference reflected signal.

[Fig. 1]

FIG.1

[Fig. 2]

FIG.2

[Fig. 3]

E2
« $\frac{\pi}{2}$ »

E3
« $\pi$ »

CL1                                                        CL2

E4
« $\frac{\pi}{2}$ »

E5

CL2,N2                          CL1,N1

# FIG.3

[Fig. 4]

FIG.4

[Fig. 5]

FIG.5

[Fig. 6]

FIG.6

[Fig. 7]

FIG.7

[Fig. 8]

FIG.8

[Fig. 9]

FIG.9

[Fig. 10]

FIG.10

[Fig. 11]

EP 4 168 736 B1

FIG.11

[Fig. 12]

FIG.12

EP 4 168 736 B1

FIG.13

32

[Fig. 14]

**FIG.14**

EP 4 168 736 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2017089489 A

**Littérature non-brevet citée dans la description**

- **BERND MEYER et al.** Dynamical low-noise microwave source for cold atom experiments. *Cornell University Library,* 24 Mars 2020

- **ALEXANDER E. KRASNOK et al.** An antenna model forthe Purcell effect. *Nature - Scientific Report,* Août 2015